# EUROPEAN PATENT APPLICATION

(11) **EP 4 513 576 A1**
(43) Date of publication of application: **26.02.2025**
(21) Application number: 24159003.3
(22) Date of filing: 22.02.2024
(51) Int. Cl.: H01L 31/107, H01L 31/0352

(54) **STRUCTURE WITH GUARD RING BETWEEN TERMINALS OF SINGLE PHOTON AVALANCHE DIODE PHOTODETECTOR AND RELATED METHOD**

(30) Priority: 22.08.2023 US 202318453390
(71) Applicant: GlobalFoundries Dresden Module One Limited Liability Company & Co. KG, 01109 Dresden (DE)
(72) Inventor: Kammler, Thorsten Erich, 01099 Dresden (DE); Zier, Manfred Michael, 01109 Dresden (DE); Dhulla, Vinit, Austin, 78735 (US); Hauser, Julia, 47058 Duisburg (DE); Dreiner, Stefan, 45277 Essen (DE); Ewering, Johannes, 47057 Duisburg (DE)
(74) Representative: Grünecker Patent- und Rechtsanwälte PartG mbB

(57) **Abstract**

The disclosure provide a structure with a guard ring between the terminals of a single photon avalanche diode photodetector (SPAD), and related methods. A structure (100) according to the disclosure includes a SPAD with an anode (108) within a doped well (104) and a cathode (110) within the doped well. A guard ring (106) includes a semiconductor material (112) within the doped well. The semiconductor material and the doped well have opposite doping polarities.

## Description

### TECHNICAL FIELD

Embodiments of the disclosure relate generally to integrated circuit (IC) structures. More specifically, various embodiments of the disclosure provide a structure with a guard ring between the terminals of a single photon avalanche diode (SPAD) photodetector, and related methods.

### BACKGROUND

A need for greater bandwidth in fiber optic network links is widely recognized. Fiber optics communications have gained prominence in telecommunications, instrumentation, cable TV, network, and data transmission and distribution. A fiber optics communication system or link includes a photodetector element. The function of the photodetector in a fiber optic communication system is to convert optical power into electrical voltage or current. Photodetectors may be formed as a standard P-I-N diode structure (positive/intrinsic/negative type conductivity) or an avalanche photodiode (APD). Although an avalanche photodiode requires higher operating voltages, which must be compensated for with respect to temperature shifts, the internal gain of the avalanche photodiode is much more sensitive to incoming radiation. Moreover, an avalanche photodiode typically provides a significant increase in the receiver signal-to-noise ratio (SNR). A single photon avalanche diode photodetector (SPAD) is an APD that is electrically biased significantly above its reverse-bias breakdown voltage, increasing sensitivity to radiation, and allowing the photodiode to operate with less damage or noise than other APDs. In microelectronic circuits, SPAD effectiveness may be limited by edge breakdown, i.e., where the electric field gradient is significantly higher at the edges of the avalanching junction and causes the diode structure to degrade at such edges.

### SUMMARY

Aspects of the present disclosure provide a structure including: a single photon avalanche diode (SPAD) photodetector including an anode within a doped well and a cathode within the doped well; and a guard ring within the doped well and between the cathode and the anode, wherein a semiconductor material of the guard ring and the doped well have opposite doping types.

Further aspects of the present disclosure provide a structure including: a doped well within a substrate; a single photon avalanche diode (SPAD) photodetector within the substrate, the SPAD including: an anode within a first portion of the doped well and having an anode contact thereto, a cathode within a second portion of the doped well and having a cathode contact thereto, wherein the cathode is horizontally distal to the anode within the doped well; and a guard ring including a semiconductor material within the doped well between the cathode and the anode, wherein the semiconductor material and the doped well have opposite doping types.

Yet another aspect of the present disclosure provides a method including: forming a single photon avalanche diode (SPAD) photodetector including an anode within a doped well and a cathode within the doped well; and forming a guard ring within the doped well and between the cathode and the anode, wherein a semiconductor material of the guard ring and the doped well have opposite doping types.

### BRIEF DESCRIPTION OF THE DRAWINGS

These and other features of this disclosure will be more readily understood from the detailed description of the various aspects of the disclosure taken in conjunction with the accompanying drawings that depict various embodiments of the disclosure, in which:
FIG. 1 provides a cross-sectional view of a structure including a single photon avalanche diode photodetector (SPAD) and guard ring according to embodiments of the disclosure.
FIG. 2 provides a plan view of a structure including a single photon avalanche diode (SPAD) photodetector and guard ring according to embodiments of the disclosure.
FIG. 3 shows a cross-sectional view of a structure according to the disclosure during operation, with shading to indicate electric field strength.
FIG. 4 shows a cross-sectional view of a structure including a SPAD and multiple guard ring regions according to embodiments of the disclosure.
FIGS. 5-8 show cross-sectional views of forming an anode region, cathode region, and guard ring within a doped well in a method according to embodiments of the disclosure.
FIGS. 9 and 10 show cross-sectional views of forming a structure with multiple guard ring regions according to embodiments of the disclosure.

It is noted that the drawings of the disclosure are not necessarily to scale. The drawings are intended to depict typical aspects of the disclosure, and therefore should not be considered as limiting the scope of the disclosure. In the drawings, like numbering represents like elements between the drawings.

### DETAILED DESCRIPTION

In the description herein, reference is made to the accompanying drawings that form a part thereof, and in which is shown by way of illustration specific exemplary embodiments in which the present teachings may be practiced. These embodiments are described in sufficient detail to enable those skilled in the art to practice the present teachings, and it is to be understood that other embodiments may be used and that changes may be made within the scope of the present teachings. The description herein is, therefore, merely illustrative.

Embodiments of the disclosure provide a structure with a guard ring between the terminals of a single photon avalanche diode (SPAD) photodetector, and related methods. Structures according to the disclosure provide a SPAD having an anode within a doped well and a cathode within the doped well. The cathode and the anode are separated within the doped well by a distance. A guard ring is coupled to a semiconductor material within the doped well and between the cathode and the anode. The semiconductor material and the doped well have opposite doping polarities. In this configuration, the guard ring can be electrically biased to partly counteract, and thus reduce, the electric field strength between the anode and the doped well. Electrically biasing the guard ring during operation of the SPAD, among other benefits, can reduce or altogether prevent instances of pre-mature edge breakdown with the SPAD structure. In certain embodiments, the structure may include differences in height and/or position of the cathode, anode, and semiconductor material to further prevent electric fields of high strength from accumulating where they are not desired.

Structures according to the disclosure operate using diodes. A diode is a two-terminal element that behaves differently from conductive or insulative materials between two points of electrical contact. Specifically, a diode provides high conductivity from one contact to the other in one direction (i.e., the "forward" direction) but provides little to no conductivity in the opposite direction (i.e., the "reverse" direction). In the case of the P-N junction, the orientation of a diode's forward and reverse directions may be contingent on the type and magnitude of voltage applied to the material composition of one or both terminals, which affect the size of the potential barrier. In the case of a junction between two semiconductor materials, the potential barrier will form along the interface between the two semiconductor materials.

An "avalanche junction," also known as an "avalanche diode," is a particular type of diode structure for bidirectional control of current flows through an integrated circuit (IC) structure. Avalanche junctions are distinct from P-N diodes by featuring a much wider depletion region, i.e., the more lightly doped region of semiconductor material between the oppositely doped terminals of the diode. Applying an electrical voltage across the wide depletion region may accelerate minority charge carriers in the insulative material to an extent that creates ionization in a crystal lattice. In turn, the accelerated minority charge carriers produce more charge carriers and more electrical ionization. This effect is known as "avalanche breakdown." In this scenario, an electrical pathway can form in either direction from one terminal to another depending on whether the diode is subject to a forward bias or a reverse bias. Avalanche diodes are distinct from other diodes, e.g., by providing a voltage drop across the two terminals that is constant and independent of the amount of current passing therethrough.

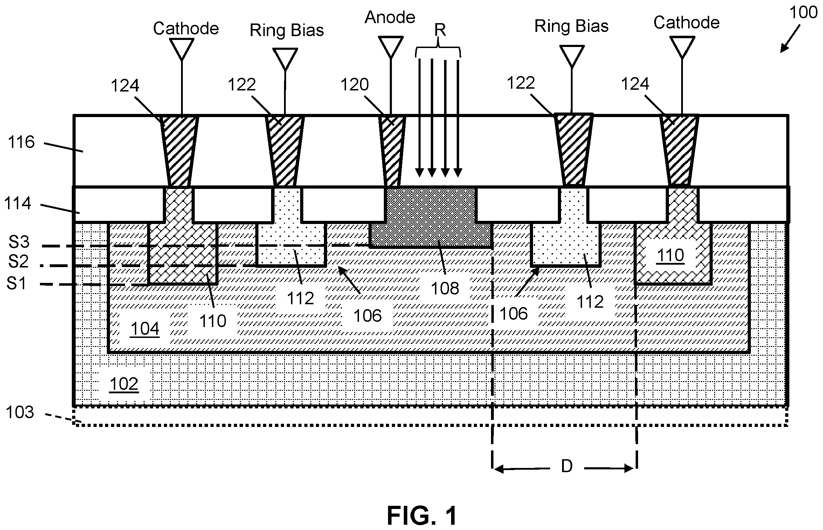

Referring to FIG. 1, a cross-sectional view of a structure 100 according to embodiments of the disclosure is shown. Structure 100 may be formed from a substrate 102 including, e.g., one or more semiconductor materials. Substrate 102 may be at least partially formed of any currently known or later developed semiconductor material, which may include without limitation: silicon, germanium, silicon germanium, and substances consisting essentially of one or more III-V compound semiconductors having a composition defined by the formula Al_{X1}Ga_{X2}In_{X3}As_{Y1}P_{Y2}N_{Y3}Sb_{Y4}, where X1, X2, X3, Y1, Y2, Y3, and Y4 represent relative proportions, each greater than or equal to zero and X1+X2+X3+Y1+Y2+Y3+Y4=1 (1 being the total relative mole quantity). Substrate 102 may be in the form of a bulk substrate, a semiconductor on insulator (SOI) substrate, and/or various other kinds of substrates. In the case of an SOI substrate, a semiconductor layer 102 of the SOI substrate may be on a buried insulator layer 103 (shown in dashed lines) composed of any currently known or later developed insulator material, e.g., any one or more of various oxides, nitrides, and/or other insulator materials discussed herein.

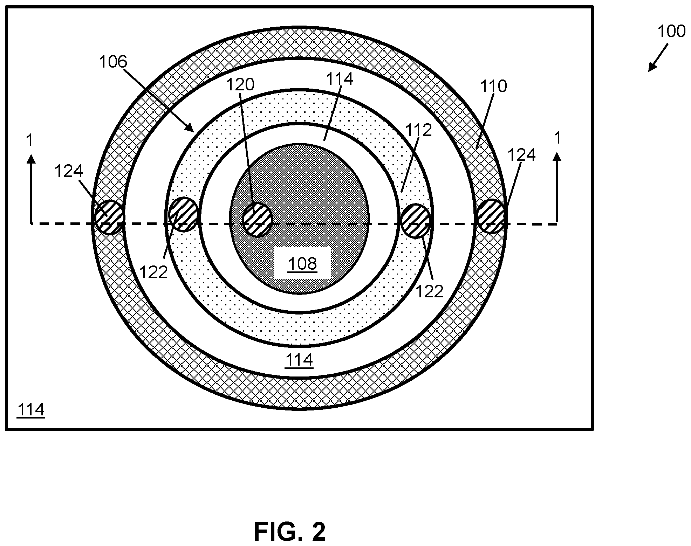

Portions of substrate 102 may include dopants, and thus may provide a doped well 104 having a doping type opposite that of substrate 102. In the art of semiconductor processing, a "well" refers to a portion of a substrate that contains a particular type and concentration of impurities (dopants) to control its conductivity. According to one example, substrate 102 may have a low amount of P-type doping. When referring to dopants, P-type dopants refer to elements introduced into semiconductor material to generate free holes by "accepting" electrons from a semiconductor atom and consequently "releasing" the hole. The acceptor atom must have one valence electron less than the host semiconductor. P-type dopants suitable for use in substrate 102 may include but are not limited to: boron (B), indium (In) and gallium (Ga). Boron (B) is the most common acceptor in silicon technology. Further alternatives include In and Ga. Ga features high diffusivity in silicon dioxide (SiO₂), and hence, the oxide cannot be used as a mask during Ga diffusion. Doped well 104 may be formed within substrate 102, e.g., by vertical ion implantation, such that an upper surface of doped well 104 is aligned, and thus shared, with the upper surface of substrate 102. Doped well 104 may have the opposite doping type from substrate 102, e.g., it may be lightly doped N-type (known as "n- doping") in the case where substrate 102 is doped p-type. N-type dopants suitable for use in doped well 104 may include but are not limited to: phosphorous (P), arsenic (Ar), antimony (Sb), bismuth (Bi), and lithium (L). Phosphorous and arsenic are the most common examples of n-type doping in integrated circuit technology. As known in the art, doping type may be notated as either "p" or "n" followed by a "plus" or "minus" sign, in which minus denotes a lower concentration than a baseline concentration and plus denotes a higher concentration than the baseline concentration. Doped well 104 thus may be distinguished from substrate 102 at least partially based on its doping concentration, dopant materials, etc. Substrate 102 may include other doped wells having the same, or different doping types, and such wells are omitted from FIG. 2 solely for clarity.

Portions of doped well 104 may include, or may be positioned below, a guard ring 106. As discussed in further detail herein, guard ring 106 is included within structure 100 to separate certain electrically active materials from each other. Guard ring 106 may take the form of a semiconductor material that is oppositely doped relative to doped well 104 and/or other adjacent regions of semiconductor material. Two portions of guard ring 106 are shown in FIG. 1, but it is understood that these two portions may be included within a single guard ring 106 surrounding an anode region 108 as shown in FIG. 2 and discussed elsewhere herein.

Embodiments of structure 100 include an anode region 108 within doped well 104 and a cathode region 110 within doped well 104. A distance D separates anode region 108 from cathode region 110. Distance D may be selected, together with the size of guard ring 106, to ensure that an avalanche junction will form within the depletion region that doped well 104 defines. Anode region 108 may be a region of semiconductor material within doped well 104 that has an opposite polarity from doped well 104, e.g., it may be more highly doped P-type than guard ring 106 ("p++ doping") to create a strong P-N junction between anode region 108 and doped well 104 thereunder. Cathode region 110 may be of the same doping type as doped well 104, but with a higher doping concentration. For instance, cathode region 110 may have "n+" doping in the case where doped well 104 has "n-" doping. Incoming radiation R to anode region 108 may produce a current pathway within structure 100. Although radiation R is illustrated as passing through and illuminating the upper (i.e., "back") side of structure 100, radiation traveling from the bottom (i.e., "front") side of structure 100 also may produce an electric current. Collectively, anode region 108, doped well 104, and cathode region 110 define a SPAD within structure 100. Guard ring 106 and its subcomponents is not considered to be part of the SPAD but may interact with the SPAD components to influence its behavior, e.g., by counteracting or preventing certain areas from having a high electric field strength as discussed herein.

A SPAD in structure 100 (made up of anode region 108, cathode region 110, and doped well 104 therebetween) operates via the same principle as other diode junctions in an integrated circuit. That is, anode region 108 and cathode region 110 provide two oppositely doped regions which allow current to flow easily from anode region 108 to cathode region 110 but resist current flow in the opposite direction. SPADs in particular are structured to operate at higher voltages than other types of diodes. In an ordinary diode, voltage and structural breakdown will occur when the voltage applied thereto exceeds an inherent peak voltage for the diode. SPADs, however, may continue to operate beyond their breakdown voltage by having an avalanche junction formed therein. Doped well 104 functions as the wider depletion region between anode region 108 and cathode region 110, enabling these portions of structure 100 to exhibit "avalanche breakdown" above its breakdown voltage. An incoming photon to anode region 108 thus will impart sufficient energy to induce a current from anode region 108 to cathode region 110, enabling regions 104, 108, 110 to detect incoming radiation.

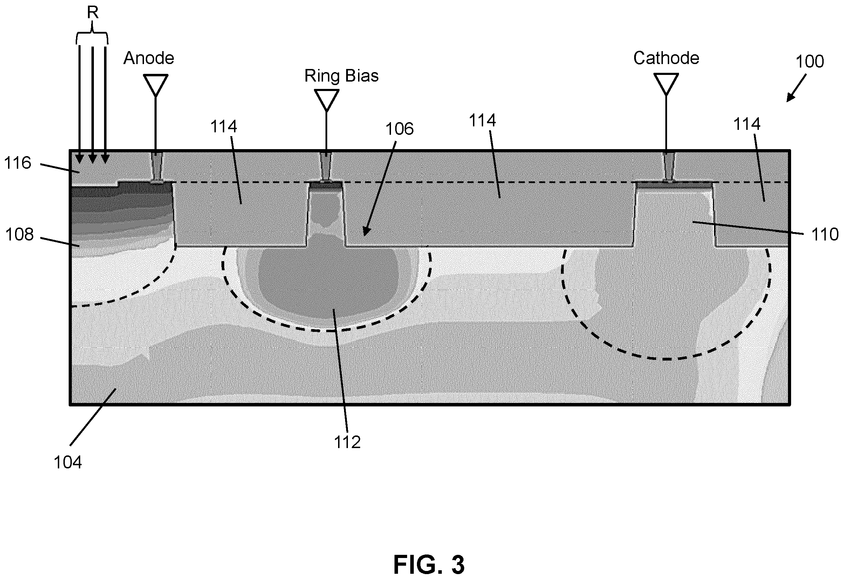

The presence of guard ring 106 of the same doping polarity as anode region 108, but in a lighter concentration, will partially oppose the induced currents through doped well 104. During operation, an operator of structure 100 may electrically bias guard ring 106 to produce an electric field that more strongly opposes electric current in the immediately adjacent portions of doped well 104 without preventing the avalanche breakdown altogether. The electric field induced by the biasing of guard ring 106 may be of opposite polarity to any electric fields produced by illumination of anode region 108, and thus may prevent current from passing through locations that are physically close to guard ring 106. Such locations typically include, for example, the corners or vertical sidewalls of anode region 108, which prevents "edge breakdown" near anode region 108 or cathode region 110. An example of such an electric field is shown in FIG. 3 and discussed in further detail elsewhere herein.

Guard ring 106 may include a semiconductor material 112 that is located between anode region 108 and cathode region 110, and of the same doping polarity as anode region 108. Semiconductor material 112 may have the same doping type as anode region 108, but in a lower concentration (e.g., it may have "p+" doping where anode region 108 has "p++ doping"). The presence of semiconductor material 112 in guard ring 106 defines a current pathway in doped well 104 between anode region 108 and cathode region 110 that passes below guard ring 106. Each region 108, 110, 112 may have a lower surface (i.e., S1 denoting the lower surface of cathode region 110, S2 denoting the lower surface of semiconductor material 112, S3 denoting the lower surface of anode region 108) to a different depth within doped well 104. The depth of semiconductor material 112 within doped well 104 may be greater (i.e., deeper) than that of anode region 108 but may be less (i.e., shallower) than that of cathode region 110. The varying depths of each region 108, 110, 112 within doped well 104 may increase the physical distance between anode region 108 and cathode region 110, and in turn, may increase the effect by which an electric field induced in semiconductor material 112 may affect the current pathway between anode region 108 and cathode region 110.

Upper portions of each region 108, 110, 112 may be separated from each other by a set of trench isolations (TIs) 114, each of which may be above doped well 104 and substrate 102. TI(s) 114 may be formed, e.g., by removing an initial portion of substrate 102 and/or doped well 104 before remaining portions of structure 100 are formed, and filling the removed semiconductor material(s) with one or more insulating materials as generally known in the art. An insulator 116 also may be formed above TI(s) 114, e.g., as an inter-level dielectric and/or other layer of insulating material to separate substrate 102 from overlying metal wiring levels. TI(s) 114 and/or insulator 116 each may include one or more dielectric materials, e.g., oxide and/or nitride insulators, and/or other insulating materials including those having a low dielectric constant (i.e., any insulating material(s) with a dielectric constant "k" of less than approximately 3.9).

Insulator 116 of structure 100 may have a set of contacts extending vertically therethrough, each of which may be formed of one or more electrically conductive materials. An anode contact 120 may be coupled to anode region 108, a guard ring contact 122 may be coupled to semiconductor material 112, and a cathode contact 124 may be coupled to cathode region 110. Each contact 120, 122, 124 may include any currently known or later developed conductive materials, e.g., tungsten (W), etc., and/or other materials suitable for use in conductive contacts or vias of a circuit structure. Contact(s) 120, 122, 124 may include refractory metal liners (not shown) along the sidewalls thereof, e.g., to reduce electromigration degradation as known in the art. One or more metal wiring layers (known as "metal levels" in the art) may be on or above contact(s) 120, 122, 124 for connecting structure 100 to other structures and/or devices. Such connections are shown schematically in FIG. 1 via an anode terminal to anode contact 120, a ring bias terminal to guard ring contact 122, and a cathode terminal to cathode contact 124. The anode and cathode terminals indicate electrical couplings to circuitry for detecting a current in structure 100 induced by radiation R. A biasing voltage may be coupled to the ring bias terminal and thus to guard ring contact 122. The biasing voltage may be set to a predetermined voltage level (e.g., by a manufacturer and/or operator of structure 100) to electrically bias guard ring 106 through semiconductor material 112.

Referring to FIG. 2, anode region 108 may be a single region of semiconductor material over doped well 104 (FIG. 1), such that guard ring 106 (including semiconductor material 112 thereof) horizontally surrounds anode region 108. Any desired number of guard ring contacts 122 to guard ring 106 may be in various locations on semiconductor material 112 (e.g., two are shown in FIG. 2) to further control the electrical biasing of guard ring 106. Although guard ring 106 is shown by example to have a substantially circular shape, semiconductor materials(s) in other shapes (e.g., elliptical, triangular, quadrilateral, polygonal having any number of sides) horizontally enclosing anode region 108 still may provide a "guard ring" shape. Cathode region 110 similarly may surround semiconductor material 112 of guard ring 106. Although cathode region 110 is shown as having a similar shape to guard ring 106, this is not necessarily required. In still further embodiments, cathode region 110 may not surround guard ring 106 and simply may be located adjacent guard ring 106 within doped well 104 (FIG. 1). TIs 114 may be horizontally between guard ring 106 and regions 108, 110 such that regions 108, 110, 112 are structurally and electrically isolated from each other. As indicated by view line 1-1 of FIG. 2 showing the perspective of FIG. 1, the multiple instances of guard ring 106, semiconductor material 112, cathode region 110, etc., in FIG. 1 each may be part of a continuous region of material.

FIG. 3 depicts a diagram of a portion of structure 100 during operation to better illustrate the effects of a biasing voltage on current flow through the SPAD (i.e., the pathway from anode region 108 to cathode region 110 through doped well 104). In FIG. 3, areas with darker shading indicate a stronger electric field and areas with lighter shading indicate a weaker electric field. Electrically biasing semiconductor material 112 of guard ring 106 induces an electric field of opposite polarity from that of the electric field induced by an incoming photon (indicated by radiation lines R). The electric field from semiconductor material 112 thus reduces the electric field strength near the boundary between anode region 108 and TI(s) 114, and similarly at the boundary between cathode region 110 and TI(s) 114. The electric field within doped well 104 below semiconductor material is stronger than the electric field alongside the upper portins of semiconductor material 112, thus preserving a current pathway through a depletion region that is wide enough to provide an avalanche junction. Other circuitry (not shown) coupled to anode region 108 and cathode region 110 may provide a complete circuit for transmitting electrical signals. Incoming radiation to anode region 108 may produce a current from anode region 108 to cathode region 110, and embodiments of the disclosure reduce or eliminate the risk of edge breakdown in the portions of doped well 104 that are near the corner(s) of anode region 108, cathode region 110, and/or TI(s) 114.

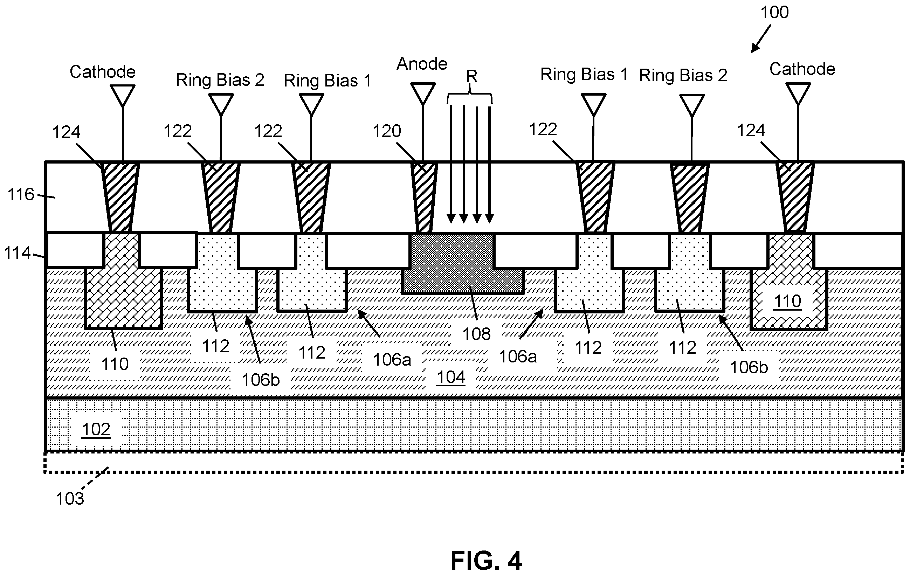

FIG. 4 depicts a further example of structure 100, in which guard ring 106 includes multiple guard ring regions 106a, 106b, each including semiconductor material 112 between anode region 108 and cathode region 110. Each guard ring region 106a, 106b may be similar in shape to other implementations of guard ring 106 discussed herein, apart from having different dimensions to be located in their respective positions. According to an example, one guard ring region 106a horizontally surrounds anode region 108 and another guard ring region 106b horizontally surrounds guard ring region 106a in addition to anode region 108. Each guard ring region 106a, 106b may be coupled to a different biasing voltage at electrical couplings "Ring Bias 1" and "Ring Bias 2" shown in FIG. 4. The different amounts of biasing may allow an operator or manufacturer to further control the electric field strength between anode region 108 and cathode region 110, and thus further influence the current pathway through doped well 104.

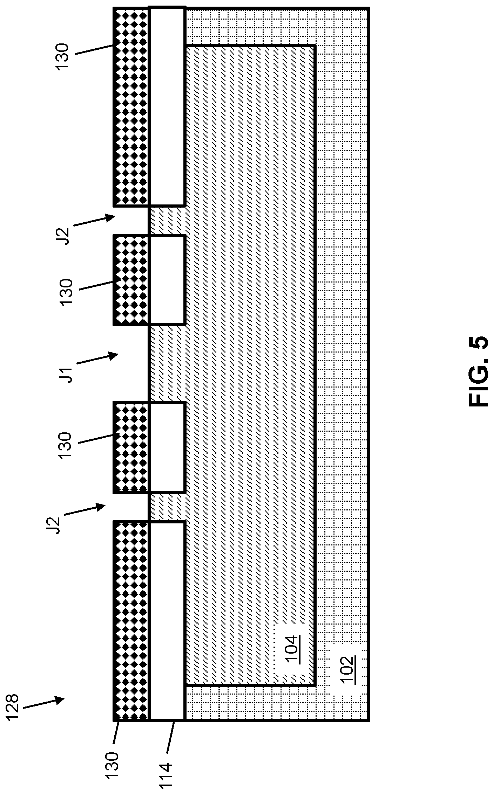

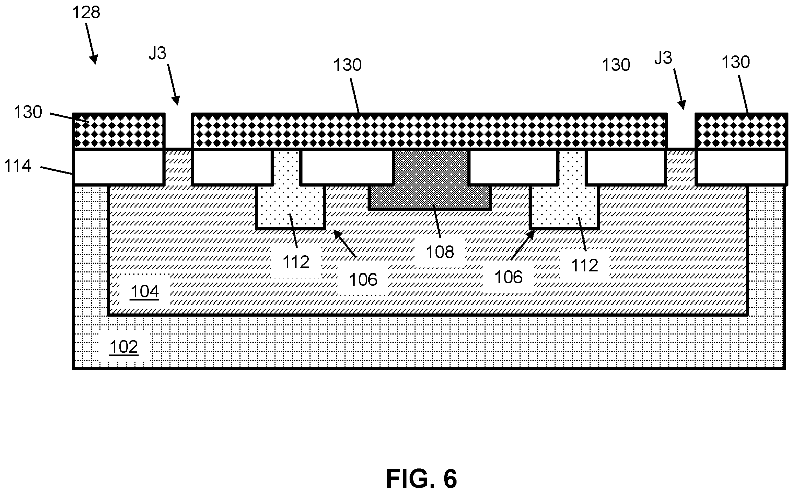

Turning to FIGS. 5 and 6, the disclosure also provides methods of forming structure 100 (FIG. 1,) in which guard ring 106 (FIG. 1) of a SPAD is capable of being electrically biased. FIG. 4 depicts an initial structure 128 in which a first set of doping masks 130, e.g., silicon dioxide and/or any other currently known or later developed insulator to prevent doping of underlying materials, is formed over substrate 102 and doped well 104, to cover certain portions of substrate 102, doped well 104, and/or TI(s) 114. In this example, substrate 102 and doped well 104 have already been doped according to conventional processing techniques. The first set of doping mask(s) 130 may include a first opening J1 shaped to dope and define the anode(s) of a SPAD and second openings J2 to dope and define the semiconductor material(s) of a guard ring. First set of doping mask(s) 130 may be structured to include openings J1, J2 as these openings are for doping two regions of the same doping type. FIG. 6 depicts using another set of doping masks 130 with third openings J3 to dope and define the cathode(s) of a SPAD. Although two different sets of doping masks(s) 130 are shown in FIGS. 5 and 6 for ease of illustration, it is understood that any number of doping mask(s) 130 may be formed in any number stages such that only certain sets (e.g., only one set) of openings J1, J2, J3 may be used to dope at the same time to better control the doping polarity and concentration in doped well 104. The doping of different materials may also be implemented in a different order from that shown in FIGS. 5 and 6.

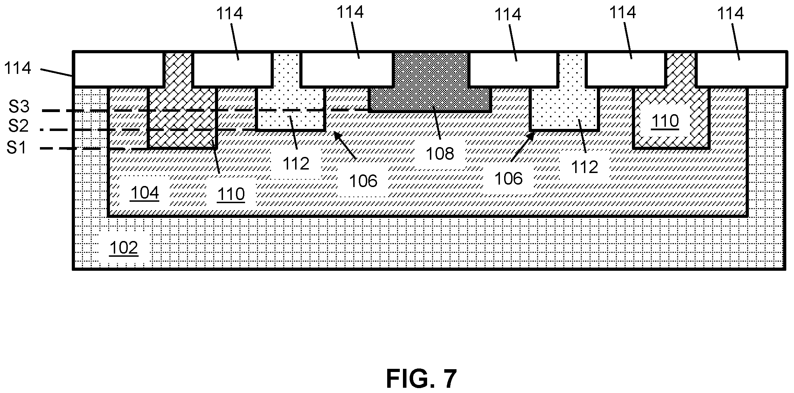

Referring to FIGS. 5-7, doping masks(s) 130 can be used to form anode region(s) 108, cathode region(s) 110, and semiconductor material(s) 114 in doped well 104. Regardless of the number of doping masks(s) 130 and openings J1, J2, J3 available at a given time, portions of doped well 104 within opening(s) J1, J2, J3 may be doped by introducing impurities (dopants) into doped well 104. In the example of doping by implantation, an ion implanter may be employed. In further examples, in-situ doping or other doping techniques may be used. To provide a SPAD having an avalanche junction, anode region 108 may be very highly doped (e.g., "p++ doping") and cathode region 110 may be highly doped with the opposite polarity (e.g., "n+ doping"), as compared to the light doping (e.g., "n- doping") in doped well 104. As discussed elsewhere herein, anode region 108 may extend less deeply into doped well 104 than cathode region 110, such that lower surface S1 of cathode region 110 is below lower surface S3 of anode region 108. Doping masks(s) 130 with second openings J2 similarly may be used to form semiconductor material 112 of guard ring 106, located between anode region 108 and cathode region 110. Semiconductor material 112 may have the same doping type as anode region 108 but with a lower doping concentration (e.g., "p+ doping" where anode region 108 has p++ doping). Semiconductor material 112 having the same doping type as anode region 108 may allow an electrical bias applied thereto to oppose any electrical fields induced near the upper surface(s) and/or corner(s) of anode region 108 and cathode region 110, as discussed herein. Semiconductor material 112 may have lower surface S2 that is vertically between lower surface S1 of cathode region 110 and lower surface S3 of anode region 108, as also discussed herein.

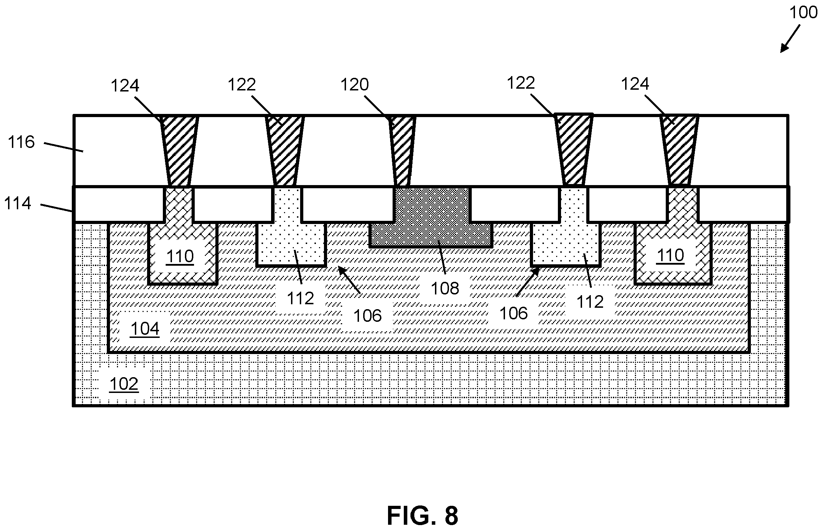

FIG. 8 depicts further processing to yield structure 100 with anode region 108, cathode region 110, and guard ring 106 therein according to embodiments of the disclosure. Insulator 116 (e.g., an ILD material or other electrical insulator discussed herein) may be formed as a single layer over TI(s) 114 and the upper surface(s) of anode region 108, semiconductor material 112, and cathode region 110. Thereafter, a set of opening(s) (not shown) may be formed by targeting and removing areas of insulator 116 material over regions 108, 110, 112. These openings may be filled with refractory metal liner(s) and conductive material to yield contacts 120, 122, 124 discussed elsewhere herein. Each contact 120, 122, 124 can then be connected to respective terminals to enable current flow from anode region 108 to cathode region 110, and to allow electrical biasing of guard ring 106.

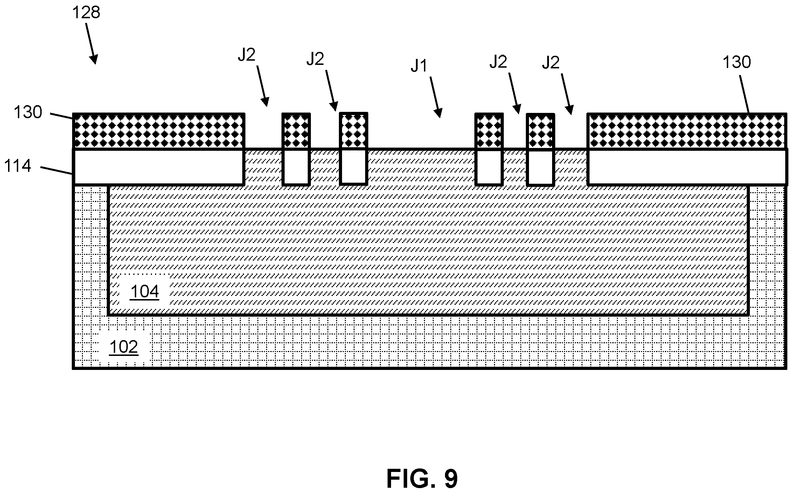

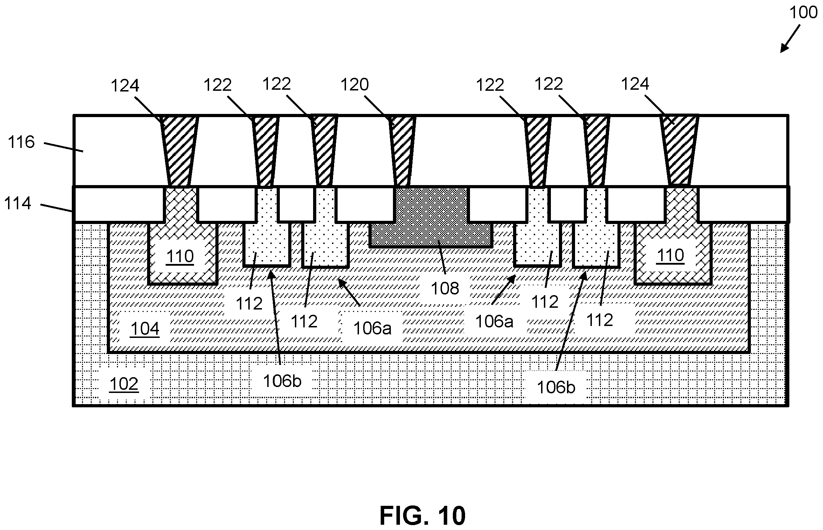

FIGS. 9 and 10 depict how methods of the disclosure may be implemented to form multiple guard ring regions 106a, 106b, e.g., as discussed herein with respect to FIG. 4. As shown in FIG. 9, doping masks 130 may include multiple second openings J2 (FIG. 9 only) in the shape of multiple guard ring regions. Portions of doped well 104 beneath each opening J2 may receive the same type of doping to produce multiple guard ring regions 106a, 106b (FIG. 10 only) where desired. Other processes discussed herein may be implemented without any changes, apart from perhaps variation in the shape of doping masks 130 having third openings J3 (see FIG. 6) shaped to form cathode region(s) 110. Guard ring contacts 122, when formed, each may be coupled to different biasing voltages such that different guard ring regions 106a, 106b may be coupled to a different biasing voltage.

Embodiments of the disclosure may provide several technical and commercial advantages, some of which here discussed herein by way of example. Electrical biasing of guard ring 106 will reduce the electrical field strength near the sidewalls and corners of anode region 108 and cathode region 110 of a SPAD, without being strong enough to prevent an avalanche junction from forming within doped well 104 between anode region 108 and cathode region 110. One benefit of inducing an opposing electric field via guard ring 106 is the ability to reduce or even prevent any occurrence of premature edge breakdown during operation of a device. In turn, embodiments of the disclosure provide easier integration of SPADs into integrated circuits by having few manufacturing differences as compared to conventional SPADs. The presence of electrically biased SPADs may allow for more reliable light detection and longer product life.

The descriptions of the various embodiments of the present disclosure have been presented for purposes of illustration, but are not intended to be exhaustive and/or limited to the embodiments disclosed. Many modifications and variations will be apparent to those of ordinary skill in the art within the scope and spirit of the described embodiments The terminology used herein was chosen to best explain the principles of the embodiments, the practical application and/or technical improvement over technologies found in the marketplace, and/or to enable others of ordinary skill in the art to understand the embodiments disclosed herein.

Various embodiments of the disclosure provide a structure with a guard ring between the terminals of a single photon avalanche diode photodetector (SPAD), and related methods. A structure according to the disclosure includes a SPAD with an anode within a doped well and a cathode within the doped well. A guard ring includes a semiconductor material within the doped well. The semiconductor material and the doped well have opposite doping polarities.

The following embodiments are explicitly disclosed.
Embodiment 1:
   A structure comprising:
   a single photon avalanche diode photodetector (SPAD) including an anode within a doped well and a cathode within the doped well; and
   a guard ring within the doped well and between the cathode and the anode, wherein a semiconductor material of the guard ring and the doped well have opposite doping types.
Embodiment 2:
   The structure of embodiment 1, wherein the guard ring includes a plurality of guard ring regions within the doped well between the cathode and the anode, wherein two of the plurality guard ring regions are coupled to different bias voltages.
Embodiment 3:
   The structure of embodiment 1 or 2, wherein the guard ring horizontally surrounds the anode.
Embodiment 4:
   The structure of embodiment 3, wherein the cathode horizontally surrounds the guard ring.
Embodiment 5:
   The structure of one of embodiments 1 to 4, wherein the guard ring includes a lower surface vertically between a lower surface of the anode and a lower surface of the cathode.
Embodiment 6:
   The structure of one of embodiments 1 to 5, wherein the doped well is in one of a bulk semiconductor substrate and a semiconductor layer of a semiconductor on insulator (SOI) substrate.
Embodiment 7:
   The structure of one of embodiments 1 to 6, wherein the semiconductor material of the guard ring and the anode have a same doping type, and wherein a dopant concentration in the anode is greater than a dopant concentration in the semiconductor material of the guard ring.
Embodiment 8:
   The structure of one of embodiments 1 to 7, further comprising a substrate, the doped well being formed within the substrate, wherein the single photon avalanche diode photodetector (SPAD) is within the substrate, wherein the anode is within a first portion of the doped well, the anode having an anode contact thereto, wherein the cathode is within a second portion of the doped well, the cathode having a cathode contact thereto, wherein the cathode is horizontally distal to the anode within the doped well, and wherein the semiconductor material of the guard ring is within the doped well between the cathode and the anode.
Embodiment 9:
   A structure comprising:
   a doped well within a substrate;
   a single photon avalanche diode photodetector (SPAD) within the substrate, the SPAD including:
      an anode within a first portion of the doped well and having an anode contact thereto,
      a cathode within a second portion of the doped well and having a cathode contact thereto, wherein the cathode is horizontally distal to the anode within the doped well; and
   a guard ring including a semiconductor material within the doped well between the cathode and the anode, wherein the semiconductor material and the doped well have opposite doping types.
Embodiment 10:
   The structure of embodiment 8 or 9, wherein the guard ring includes a plurality of guard ring regions within the doped well between the cathode and the anode, wherein two of the plurality guard ring regions are coupled to different bias voltages.
Embodiment 11:
   The structure of one of embodiments 8 to 10, wherein the guard ring horizontally surrounds the anode.
Embodiment 12:
   The structure of embodiment 11, wherein the cathode horizontally surrounds the guard ring.
Embodiment 13:
   The structure of one of embodiments 8 to 12, wherein the guard ring includes a lower surface vertically between a lower surface of the anode and a lower surface of the cathode.
Embodiment 14:
   The structure of one of embodiments 8 to 13, wherein the doped well is in one of a bulk semiconductor substrate and a semiconductor layer of a semiconductor on insulator (SOI) substrate.
Embodiment 15:
   The structure of one of embodiments 8 to 14, wherein the semiconductor material and the anode have a same doping type, and wherein a dopant concentration in the anode is greater than a dopant concentration in the semiconductor material.
Embodiment 16:
   A method comprising:
   forming a single photon avalanche diode photodetector (SPAD) including an anode within a doped well and a cathode within the doped well; and
   forming a guard ring within the doped well and between the cathode and the anode, wherein a semiconductor material of the guard ring and the doped well have opposite doping types.
Embodiment 17:
   The method of embodiment 16, wherein forming the guard ring includes forming a plurality of guard ring regions within the doped well between the cathode and the anode, wherein two of the plurality guard ring regions are coupled to different bias voltages.
Embodiment 18:
   The method of embodiment 16 or 17, further comprising applying a bias voltage to the semiconductor material through the guard ring to reduce an electric field strength within the doped well.
Embodiment 19:
   The method of one of embodiments 16 to 18, wherein forming the guard ring causes the semiconductor material to horizontally surround the anode.
Embodiment 20:
   The method of one of embodiments 16 to 19, wherein forming the guard ring includes forming a lower surface of the guard ring vertically between a lower surface of the anode and a lower surface of the cathode.
Embodiment 21:
   The method of one of embodiments 16 to 20, further comprising forming the doped well in one of a bulk semiconductor substrate and a semiconductor layer of a semiconductor on insulator (SOI) substrate.
Embodiment 22:
   The method of one of embodiments 16 to 21, wherein the structure of one of embodiments 1 to 15 is formed.
   At least in the embodiments above, the term "include" and its variants may be interpreted as meaning that an embodiment includes stated features, while not necessarily excluding the presence of other features that are not explicitly stated.

## Claims

1. A structure comprising:
a single photon avalanche diode photodetector (SPAD) including an anode within a doped well and a cathode within the doped well; and
a guard ring within the doped well and between the cathode and the anode, wherein a semiconductor material of the guard ring and the doped well have opposite doping types.

2. The structure of claim 1, wherein the guard ring includes a plurality of guard ring regions within the doped well between the cathode and the anode, wherein two of the plurality guard ring regions are coupled to different bias voltages.

3. The structure of claim 1 or 2, wherein the guard ring horizontally surrounds the anode.

4. The structure of claim 3, wherein the cathode horizontally surrounds the guard ring.

5. The structure of one of claims 1 to 4, wherein the guard ring includes a lower surface vertically between a lower surface of the anode and a lower surface of the cathode.

6. The structure of one of claims 1 to 5, wherein the doped well is in one of a bulk semiconductor substrate and a semiconductor layer of a semiconductor on insulator (SOI) substrate.

7. The structure of one of claims 1 to 6, wherein the semiconductor material of the guard ring and the anode have a same doping type, and wherein a dopant concentration in the anode is greater than a dopant concentration in the semiconductor material of the guard ring.

8. The structure of one of claims 1 to 7, further comprising:
a substrate, the doped well being formed within the substrate,
wherein the single photon avalanche diode photodetector (SPAD) is within the substrate,
wherein the anode is within a first portion of the doped well, the anode having an anode contact thereto,
wherein the cathode is within a second portion of the doped well, the cathode having a cathode contact thereto,
wherein the cathode is horizontally distal to the anode within the doped well, and
wherein the semiconductor material of the guard ring is within the doped well between the cathode and the anode.

9. A method comprising:
forming a single photon avalanche diode photodetector (SPAD) including an anode within a doped well and a cathode within the doped well; and
forming a guard ring within the doped well and between the cathode and the anode, wherein a semiconductor material of the guard ring and the doped well have opposite doping types.

10. The method of claim 9, wherein forming the guard ring includes forming a plurality of guard ring regions within the doped well between the cathode and the anode, wherein two of the plurality guard ring regions are coupled to different bias voltages.

11. The method of claim 9 or 10, further comprising applying a bias voltage to the semiconductor material through the guard ring to reduce an electric field strength within the doped well.

12. The method of one of claims 9 to 11, wherein forming the guard ring causes the semiconductor material to horizontally surround the anode.

13. The method of one of claims 9 to 12, wherein forming the guard ring includes forming a lower surface of the guard ring vertically between a lower surface of the anode and a lower surface of the cathode.

14. The method of one of claims 9 to 13, further comprising forming the doped well in one of a bulk semiconductor substrate and a semiconductor layer of a semiconductor on insulator (SOI) substrate.

15. The method of one of claims 9 to 14, wherein the structure of one of claims 1 to 8 is formed.
